# EUROPÄISCHE PATENTSCHRIFT

(11) **EP 0 863 691 B1**
(45) Veröffentlichungstag und Bekanntmachung des Hinweises auf die Patenterteilung: **17.11.2004**
(21) Anmeldenummer: 98103871.4
(22) Anmeldetag: 05.03.1998
(51) Int. Cl.: H05K 7/14, H01R 12/04, H01R 12/32, H01R 31/06

(54) **Elektrisches Gerät**
Electrical apparatus
Appareil électrique

(30) Priorität: 07.03.1997 DE 19709556
(43) Veröffentlichungstag der Anmeldung: 09.09.1998
(73) Patentinhaber: HONEYWELL AG, 63067 Offenbach am Main (DE)
(72) Erfinder: Hinkelmann, Horst, 71101 Schönaich (DE); Walter, Achim, Dipl.-Ing., 75446 Wiernsheim (DE); Bayer, Dieter, Dipl.-Ing., 71032 Böblingen (DE); Maier, Dieter, 71093 Weil i. Schönbuch (DE)
(74) Vertreter: Leson, Thomas Johannes Alois, Dipl.-Ing.

(56) Entgegenhaltungen:
- DE-A- 4 223 193
- DE-A- 4 412 270
- GB-A- 2 014 367
- US-A- 4 431 248

## Beschreibung

Die vorliegende Erfindung bezieht sich auf ein elektrisches Gerät nach dem Gattungsbegriff des Patentanspruches 1.

Elektrische Geräte und insbesondere elektronische Regler werden über eine Vielzahl von Leitungen an verschiedene Stellglieder oder auch an andere Geräte angeschlossen. Im einen Fall werden elektrische Anschlüsse über Klemmleisten bevorzugt; im anderen Fall werden bevorzugt Flachbandkabel verwendet. Aus Kostengründen ist es jedoch unerwünscht, beide Anschlußarten an dem Regler vorzusehen.

Es ist daher die Aufgabe der vorliegenden Erfindung, ein elektrisches Gerät vorzugeben, das den elektrischen Anschluß des Gerätes in unterschiedlicher Weise ermöglicht.

Die Lösung dieser Aufgabe gelingt gemäß den kennzeichnenden Merkmalen des Patentanspruches 1. Weitere vorteilhafte Ausgestaltungen des erfindungsgemäßen Gerätes sind den abhängigen Ansprüchen entnehmbar.

Anhand der Figuren der beiliegenden Zeichnung sei im folgenden ein Ausführungsbeispiel des Gerätes gemäß der Erfindung näher beschrieben. Es zeigen:
- Fig. 1: die Rückseite eines Regelgerätes mit herausgeschobenen Verbindungsmodulen;
- Fig. 2: eine rückwärtige Teilansicht eines Regelgerätes sowie einen Verbindungsmodul, bei dem Modulgehäuse und zwei unterschiedliche Adapterplatten getrennt dargestellt sind;
- Fig. 3a: eine erste Adapterplatte;
- Fig. 3b: das Modulgehäuse zur Aufnahme der Adapterplatte; und
- Fig. 3c: das Modulgehäuse mit einer eingesetzten zweiten Adapterplatte.

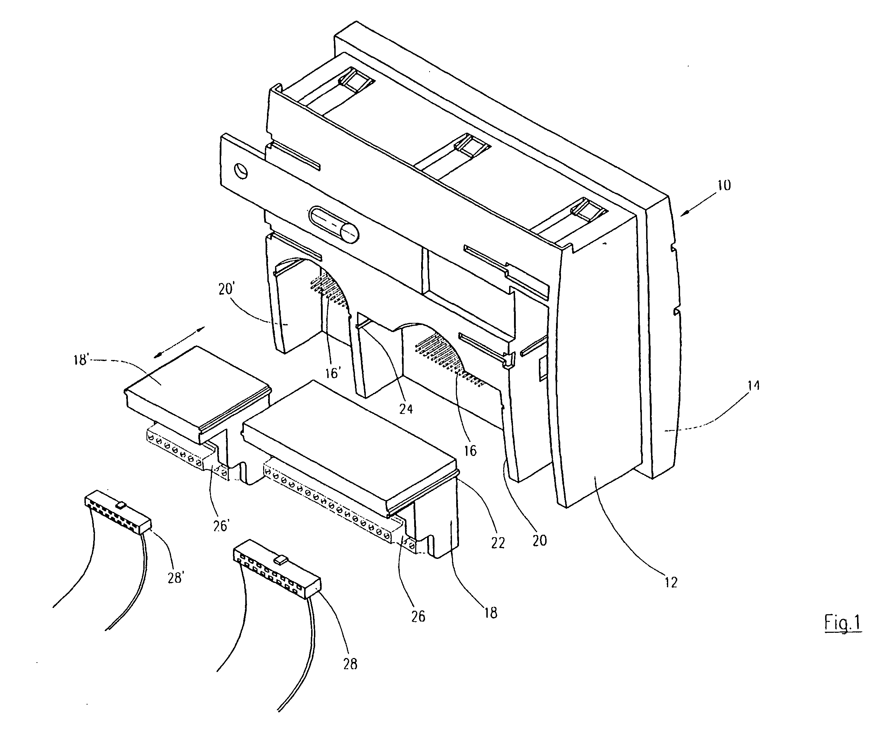

Gemäß Fig. 1 ist die Rückseite eines Regelgerätes 10 dargestellt, welches ein Gehäuse 12 mit einer Frontplatte 14 aufweist. Auf der Rückseite des Regelgerätes 10 sind zwei Stiftleisten 16, 16' als Mehrfachkontakte erster Bauart angeordnet, die dem elektrischen Anschluß des Regelgerätes dienen. Zwei als Steckblöcke ausgebildete Verbindungsmodule 18, 18' sind in rückwärtige Ausnehmungen 20, 20' des Gehäuses 12 einschiebbar, wobei sie mit entsprechenden Stegen 22 in Nuten 24 am Gehäuse 12 eingreifen. Die Verbindungsmodule 18, 18' schließen die Stiftleisten 16, 16' an Klemmleisten 26, 26' an. Alternativ können Flachbandkabelstecker 28, 28' über die Verbindungsmodule 18, 18' an die Stifleisten 16, 16' angeschlossen werden.

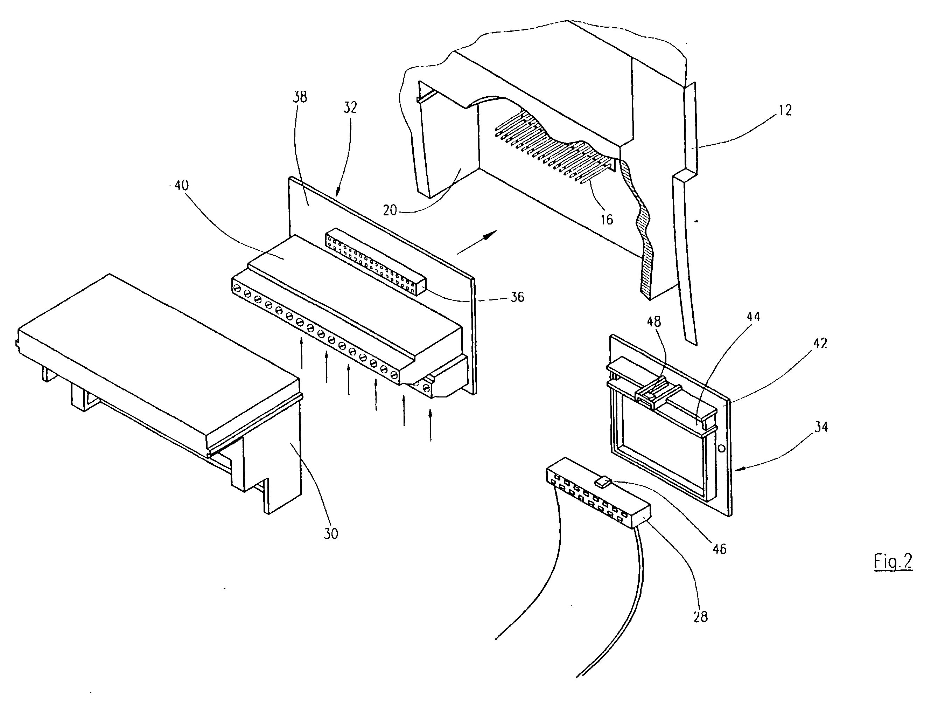

Gemäß Fig. 2 bestehen die Verbindungsmodule 18, 18' aus einem Modulgehäuse 30, in das wahlweise eine erste Adapterplatte 32 bzw. eine zweite Adapterplatte 34 einsetzbar ist. Die erste Adapterplatte trägt eine mit der Stiftleiste 16 zusammenwirkende Buchsenleiste 36 als ein Mehrfachkontakt zweiter Bauart. Die Buchsenleiste 36 ist auf einer gedruckten Schaltungsplatine 38 angeordnet und ist über entsprechende Leiterbahnen mit wenigstens einer Klemmleiste 40 als ein Mehrfachkontakt dritter Bauart elektrisch verbunden. Die erste Adapterplatte 32 besteht aus der Leiterplatte 38 und der darauf angeordneten Buchsenleiste 36 bzw. Klemmleiste 40.

Die zweite Adapterplatte 34 besteht aus einer Platte 42, die einen Steckerrahmen 44 trägt, in den der Flachbandkabelstecker 28 eingesteckt wird, wobei er mit einer Nase 46 durch eine federnde Rastklemme 48 gehalten wird.

Fig. 3a ist eine rückwärtige Ansicht der ersten Adapterplatte 32 aus Fig. 2. Man erkennt eine Reihe von Durchkontaktierungen 50 in der Leiterplatte 38. durch die die Stiftleiste 16 am Regelgerät in die auf der anderen Seite der Leiterplatte 38 befindliche Buchsenleiste 36 geschoben wird. Die Durchkontaktierungen 50 stehen über nicht-dargestellte Leiterbahnen mit Kontaktstiften 52 elektrisch in Verbindung, wobei die Kontaktstifte 52 ihrerseits mit den Klemmen der Klemmleiste 40 unter der Leiterplatte 38 elektrisch verbunden sind. Die Leiterplatte 38 ist ferner mit zwei Zentrierbohrungen 54, 54' versehen.

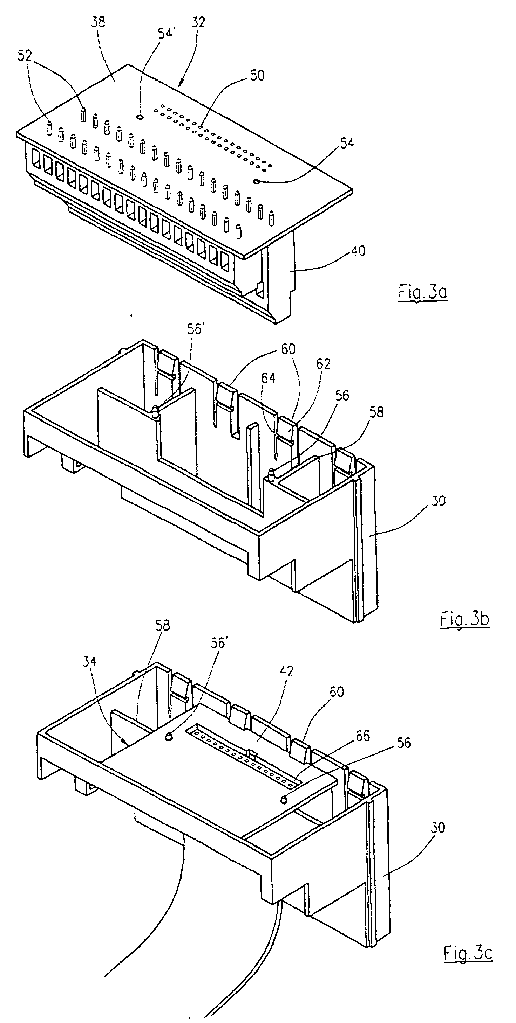

Fig. 3b zeigt das Modulgehäuse 30, in das die Adapterplatte 32 gemäß Fig. 3a einsetzbar ist. Hierbei greifen zwei Zentrierstifte 56, 56', die an dem Modulgehäuse 30 angeformt sind, in die Zentrierbohrungen 54, 54' der Leiterplatte 38. Das Modulgehäuse 30 ist bezüglich seiner Innenabmessung auf die Außenabmessung der Leiterplatte 38 abgestimmt und weist Stützrippen 58 auf, auf denen die Leiterplatte 38 zur Anlage gelangt, wenn sie in das Modulgehäuse 30 eingesetzt wird. Federnde Rastnasen 60, von denen mehrere entlang einer Seitenkante des Modulgehäuses 30 vorgesehen sind, weisen eine schräge Auflauffläche 62 und auf die Dicke der Leiterplatte 38 abgestimmte Nuten 64 auf, in die die Leiterplatte 38 einschnappt, wenn diese von oben in das Modulgehäuse 30 gedrückt wird.

Fig. 3c zeigt das Modulgehäuse 30 mit eingesetzter zweiter Adapterplatte 34, wobei gegenüber Fig. die Rückseite der zweiten Adapterplatte 34 sichtbar ist. Auch die zweite Adapterplatte 34 weist Zentrierbohrungen auf, mit denen sie die Zentrierstifte 56, 56' übergreift, wenn sie sich auf der Stützrippe 58 abstützt und durch die Rastnasen 60 verriegelt wird. Die Platte 42 ist mit einem rechteckförmigen Ausschnitt 66 versehen, hinter dem der Flachbandkabelstecker 28 liegt, wenn er in die Adapterplatte 34 eingesetzt ist (Fig. 2).

Es versteht sich. daß vorstehend nur ein Ausführungsbeispiel beschrieben wurde und daß z.B. anstelle von Stiftleisten. Buchsenleisten und Klemmleisten, welche Kontakte in einer geraden Reihe vorgeben, auch eine andere Kontaktanordnung mit Kontakten. z.B. auf einem Kreis zugrunde liegen kann.

## Patentansprüche

1. Elektrisches Gerät (10), insbesondere elektronischer Regler, mit wenigstens einer Stiftleiste (16,16') auf der Rückseite des Gerätes zum elektrischen Anschluß des Gerätes, **gekennzeichnet durch** folgende Merkmale:
a) wenigstens ein als Steckblock ausgebildeter Verbindungsmodul (18,18') ist in das Gerät (10) und auf die Stiftleiste (16,16') aufschiebbar,
b) der Verbindungsmodul (18,18') umfaßt ein Modulgehäuse (30), in welches eine Adapterplatte (32,34) einsetzbar ist, welche Adapterplatte wahlweise umfaßt:
α) eine Leiterplatte (38), auf der eine mit der Stiftleiste (16,16') in Eingriff gelangende Buchsenleiste (36) sowie wenigstens eine Klemmenleiste (40) angeordnet ist, wobei die Buchsenleiste und die Klemmenleiste über Leiterbahnen der Leiterplatte (38) elektrisch verbunden sind, oder
β) eine Platte (42), die mit einer auf die Stiftleiste (16,16') ausgerichteten Öffnung (66) und einer Halteeinrichtung (44) für einen Flachbandkabelstecker (28,28') versehen ist.

2. Gerät nach Anspruch 1. **dadurch gekennzeichnet, daß** das Modulgehäuse (30) und die Adapterplatte (32,34) mit zusammenwirkenden Führungsmitteln (54,54';56,56') versehen sind.

3. Gerät nach Anspruch 2, **dadurch gekennzeichnet, daß** die Führungsmittel durch Stifte (56,56') und Bohrungen (54,54') vorgegeben sind.

4. Gerät nach einem der Ansprüche 1 bis 3,**dadurch gekennzeichnet, daß** das Modulgehäuse (30) und das Gerät (10,12,14) mit zusammenwirkenden Führungsmitteln (22,24) versehen sind.

5. Gerät nach Anspruch 4, **dadurch gekennzeichnet, daß** die Führungsmittel durch Nuten und Führungsleisten vorgegeben sind.

6. Gerät nach einem der Ansprüche 1 bis 3, **dadurch gekennzeichnet, daß** das Modulgehäuse (30) mit Stützrippen (58) für die Adapterplatte (32,34) versehen ist und federnde Rastzungen (60) aufweist, um die Adapterplatte (32,34) in einer Rastverbindung aufzunehmen, wenn sie auf den Stützrippen ruht.

## Claims

1. Electrical appliance (10), in particular an electronic controller, with at least one pin connection strip (16, 16') on the back of the appliance for the electrical connection of the appliance, **characterized by** the following features:
a) at least one connection module (18, 18') configured as a plug block is pluggable into the appliance (10) and on to the pin connection strip (16, 16'),
b) the connection module (18, 18') comprises a module casing (30) into which an adapter plate (32, 34) is insertable, the said adapter plate optionally comprising:
α) a printed circuit board (38) on which a socket strip (36) engaging with the pin connection strip (16, 16') and at least one terminal block (40) are arranged, the socket strip and terminal block being electrically connected by interconnection tracks of the printed circuit board (38), or
β) a plate (42) which is provided with an opening (66) coming in register with the pin connection strip (16, 16') and a retaining device (44) for a flat ribbon cable plug (28, 28').

2. Appliance according to Claim 1, **characterized in that** the module casing (30) and the adapter plate (32, 34) are provided with cooperating guide means (54, 54'; 56, 56').

3. Appliance according to Claim 2, **characterized in that** the guide means are presented as pins (56, 56') and holes (54, 54').

4. Appliance according to any one of Claims 1 to 3, **characterized in that** the module casing (30) and the appliance (10, 12, 14) are provided with cooperating guide means (22, 24).

5. Appliance according to Claim 4, **characterized in that** the guide means are presented as grooves and guide beads.

6. Appliance according to any one of Claims 1 to 3, **characterized in that** the module casing (30) is provided with support ribs (58) for the adapter plate (32, 34) and has springy snap-in tongues (60) to hold the adapter plate (32, 34) in a snap fastening when it rests on the support ribs.

## Revendications

1. Appareil électrique (10), en particulier régulateur électronique, avec au moins une barrette à broches (16, 16') sur la face arrière de l'appareil pour le raccordement électrique de celui-ci, **caractérisé**
a) en ce qu'au moins un module de liaison (18, 18') conçu comme un bloc enfichable est apte à être glissé dans l'appareil (10) et sur la barrette à broches (16, 16'),
b) en ce que le module de liaison (18, 18') comprend un boîtier de module (30) dans lequel peut être insérée une plaque adaptatrice (32, 34), laquelle comprend au choix :
α) une carte à circuits imprimés (38) sur laquelle sont disposées une barrette à douilles (36) qui vient en contact avec la barrette à broches (16, 16'), et au moins une borne plate (40), la barrette à douilles et la borne plate étant reliées électriquement par l'intermédiaire de pistes conductrices de la carte (38), ou
β) une plaque (42) qui est pourvue d'une ouverture (66) dirigée vers la barrette à broches (16, 16') et d'un dispositif de fixation (44) pour une fiche de câble plat (28, 28').

2. Appareil selon la revendication 1, **caractérisé en ce que** le boîtier de module (30) et la plaque adaptatrice (32, 34) sont pourvus de moyens de guidage (54, 54' ; 56, 56') qui coopèrent.

3. Appareil selon la revendication 2, **caractérisé en ce que** les moyens de guidage sont définis par des tiges (56, 56') et des trous (54, 54').

4. Appareil selon l'une des revendications 1 à 3, **caractérise en ce que** le boîtier de module (30) et l'appareil (10, 12, 14) sont pourvus de moyens de guidage (22, 24) qui coopèrent.

5. Appareil selon la revendication 4, **caractérisé en ce que** les moyens de guidage sont définis par des rainures et des rebords de guidage.

6. Appareil selon l'une des revendications 1 à 3, **caractérisé en ce que** le boîtier de module (30) est pourvu de nervures d'appui (58) pour la plaque adaptatrice (32, 34) et présente des languettes d'encliquetage élastiques (60) pour recevoir la plaque adaptatrice (32, 34) dans une liaison d'encliquetage lorsqu'elle repose sur lesdites nervures d'appui.
